Europäisches Patentamt

European Patent Office

Office européen des brevets

(11) Publication number: **0 219 017**
**A1**

## (12) EUROPEAN PATENT APPLICATION

(21) Application number: **86113733.9**

(22) Date of filing: **03.10.86**

(51) Int. Cl.⁴: **D01H 15/00 , H03K 17/95**

(30) Priority: **07.10.85 GB 8524674**
**30.01.86 GB 8602265**

(43) Date of publication of application:
**22.04.87 Bulletin 87/17**

(84) Designated Contracting States:
**CH DE FR GB IT LI**

(71) Applicant: **MASCHINENFABRIK RIETER AG**
**Postfach 290**
**CH-8406 Winterthur(CH)**

(72) Inventor: **Meyer, Urs**
**Hohfurristrasse 1**
**CH-8172 Niederglatt(CH)**

(54) **Locating systems.**

(57) In a textile machine (not shown) each operating position has a magnet (10). A travelling service tender (not shown) movable on a path DL, DR has at least two elements (12, 14) responsive to the field of the magnet at a selected position. A control system on the tender responds to the elements to bring the tender into an alignment in which the elements are symmetrically disposed relative to the axis A of the magnet. Means is provided to compensate variations in signal levels due to tolerances in spacing of the elements 12, 14 from the magnet 10 along axis A.

Fig. 1

EP 0 219 017 A1

## LOCATING SYSTEMS

The present invention relates to developments in the systems disclosed in a European Patent Application No. 84105175.8 (Publication No. 126 373, published on 28th November 1984), the full disclosure of which is hereby incorporated in the present specification by reference. That European Patent Application is hereinafter referred to as the "prior application".

The prior application describes and illustrates positioning systems for selectively locating relatively movable parts in predetermined relative positions. For example, one such part may be provided by a locating element ("marker") on one operating station of a multi-station yarn handling machine, and the other part may be provided in a locating device on a service tender movable past the stations of the machine. In the preferred embodiment disclosed in the prior application, the locating marker is provided by a profile and the locating device is provided by a profile sensor adapted to mechanically contact the profile during a locating operation. In addition, the prior application discloses control systems responsive to a signal output from such a sensor to perform a locating operation.

The control and locating system disclosed in the prior application are not limited to use with the profile sensor disclosed in that application. On page 61 of published European Patent Specification No. 126373, reference is made to non-contact sensors using light beams or magnetic fields.

A non-contact system for positioning a travelling service device relative to a ring spinning machine is shown in US Patent Specification No. 3902308. That system employs an optical device relying upon reflection of light beams from the housings of the spindles of the machine. Such a system is convenient in that it requires no modifications in the ring spinning machine itself; on the other hand, its accuracy is likely to vary with the conditions of use.

The present invention provides a non-contact locating apparatus based on magnetic fields and suitable for use in positioning a travelling service device relative to operating stations of a multi-station textile ("yarn-handling") machine.

The present invention provides a textile machine comprising a plurality of operating stations, each of which has an individual locating element adapted to generate an individual magnetic field, and a service device, the device and the stations being arranged for relative movement, a locating apparatus associated with said service device and adapted to respond to the magnetic fields of the elements to produce output signals, and control means for controlling relative movement of the service device and the operating stations in response to output signals produced by the locating apparatus.

The present invention may employ a locating apparatus comprising a pair of magnetic field-sensitive elements, the instantaneous state of each such element being dependent in use upon the field conditions to which it is subjected, and means responsive to the states of the field-sensitive elements.

Each locating element preferably comprises a field-generating member to generate a magnetic field, which is invariant over time at least during a locating operation. The field-sensitive element(s) may be Hall devices or magnetic flux sensitive resistors.

The field generated by the field-generating member is preferably substantially symmetrical about a predetermined axis, at least in one plane containing the axis.

In the preferred embodiment, predetermined relative positioning of the field-generating member and two field-sensitive elements is defined by a condition in which the axis of symmetry of the field generated by the field-generating member substantially bisects a straight-line lying in the said plane of symmetry and joining the said field-sensitive elements while inter secting that straight line substantially at right angles thereto. The arrangement is also preferably such that relative movement of the field-generating member and field-sensitive elements is possible in directions substantially parallel to the said straight line.

The means responsive to the states of the field-sensitive elements may be adapted to respond to signals, preferably electrical, which may be generated or affected by the field-sensitive elements in dependence upon the states thereof. For example, each field-sensitive element may be adapted to generate a signal in the form of a current flow as the element moves through a spatially varying magnetic field. Alternatively, the or each such element may be adapted to affect an electrical signal by presenting varying resistance to the flow of a current in dependence upon its position in a magnetic field. The various signals may be detected by current sensitive, voltage sensitive or impedance sensitive circuitry.

The means responsive to the states of the field-sensitive elements may be adapted to detect a predetermined signal pattern in the electrical signals generated or affected by the field-sensitive elements. The predetermined signal pattern is produced by the field-sensitive elements in response to the field generated by a field-generating member. A desired relative disposition (or location) of the field-sensitive elements relative to the field-generating member is then indicated by a predetermined portion of said signal pattern.

As described in the prior application, the locating apparatus may be associated with moving means for moving a service tender. The moving means may be controlled by reference to the locating apparatus so as to bring the parts into a desired relative disposition.

The means responsive to the states of the elements may comprise means for comparing those states. The means for comparing the states of the elements can be adapted to compare signals generated or affected by such elements, a predetermined relationship between those signals representing desired positioning relative to the field-generating member. For example, the comparing means may be adapted to generate a difference signal representing the instantaneous difference between signals from the field-sensitive elements, and a substantially zero difference may be arranged to represent the desired positioning of the elements relative to the field-generating member. Such a system may operate in accordance with the proposal on page 69 of published European Patent Specification No. 126373 in accordance with which "left" and "right" signals are balanced against each other to indicate desired positioning. An additional signal can be generated to ensure that the field-sensitive elements are subjected to the field of the field-generating member when balance of the signals from the field-sensitive elements is achieved. The signal pattern referred to above may then be made up of a predetermined combination of the individual signals.

By way of example, embodiments of the invention will now be described with reference to the accompanying diagrammatic drawings, in which

Fig. 1 is a plan view of a single field-generating member with a set of associated field-sensitive elements,

Fig. 2 is a signal diagram showing output signals from the field-sensitive elements in the course of movement thereof relative to the field-generating member of Fig. 1,

Fig. 3 shows a block circuit diagram for processing the signals shown in Fig. 2,

Fig. 4 shows the signal output from the circuit shown in Fig. 3,

Fig. 5 shows an alternative signal pattern to that represented in Figs. 2 and 4,

Fig. 6 shows a block circuit diagram for processing the signals shown in Fig. 5,

Fig. 7 shows a modification of the circuit of Fig. 6,

Fig. 8A and 8B show different possible signal outputs from the circuit of Fig. 7,

Fig. 9 shows circuitry alternative to that shown in Fig. 6,

Fig. 10 is a diagrammatic representation of the signal pattern produced by the arrangement shown in Fig. 9,

Figs. 11 to 14 are copies of Figures 1 to 4 respectively of the prior application,

Fig. 15 and 16 are copies of Figures 9 and 10 respectively of the prior application,

Fig. 17 is a copy of Figure 19 of the prior application,

Fig. 18 is an illustration of a modification of part of the equipment shown in Figures 12 to 14 to adapt it for use in accordance with the present invention, and

Figs. 19A and B and

Figs. 20 and 21 are diagrams for use in explanation of various modifications of the embodiments shown in other Figures.

BASIC ELEMENTS

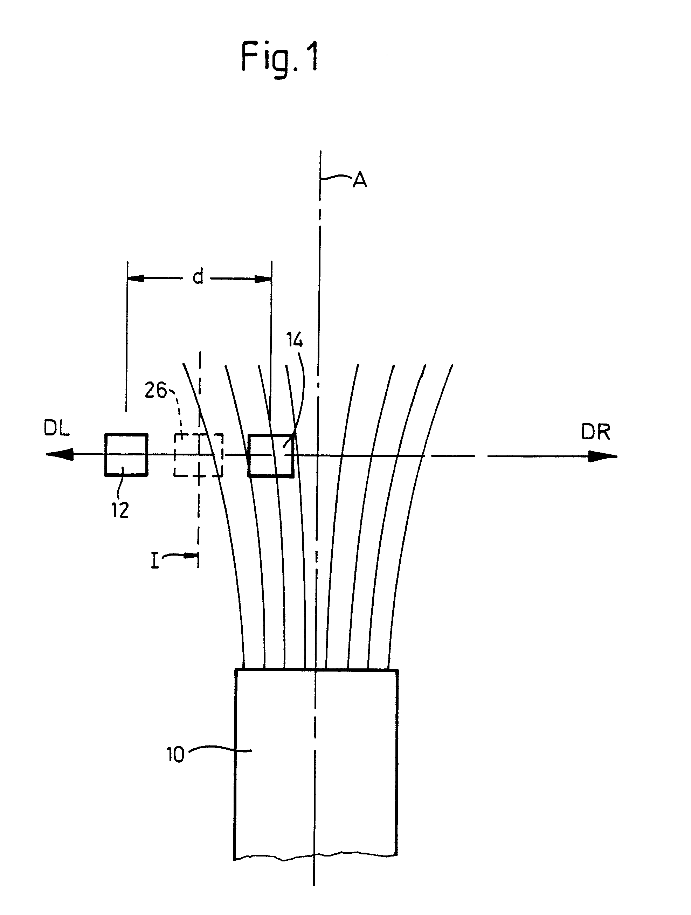

In Fig. 1, reference numeral 10 indicates part - (one pole) of a magnet producing a magnetic field - (indi cated by the so-called lines of force emanating from the illustrated magnet pole). The field is assumed to be symmetrical about a predetermined longitudinal axis A at least in the plane of the drawing. In the preferred arrangement, magnet 10 is an elongated cylinder (longitudinal axis A) and the magnetic field is symmetrical in three dimensions around the axis A. The field is assumed invariant in time, e.g. magnet 10 is a permanent magnet. For ease of description of the principle, magnet 10 is assumed to be stationary; it represents a location "mark" in relation to which a relatively movable object is to be located.

The relatively movable object (not shown) is assumed to be movable in opposed directions DL and DR lying in the plane of the drawing and intersecting the axis A at right angles. Direction DR will be assumed for purposes of explanation. The object carries two Hall semi-conductor devices 12, 14 respectively, for example of the type supplied by Siemens AG of Munich, FRG under the name "Position Hall Sensors". A suitable type is that supplied by Siemens AG under the designation KSY 10.

Devices 12, 14 are fixed relative to the object and are spaced by a known distance d along the direction of movement, with the device 14 leading in direction DR. An imaginary axis I can be defined midway between devices 12, 14, considered in the direction DR, with axis I parallel to Axis A. "Perfect location" of the object relative to magnet 10 can be (arbitrarily) defined as coincidence of the axes I and A (with the object stationary), and acceptable location is achieved if the object is brought to a standstill within some defined tolerance band to either side (along the direction (DR) of perfect location.

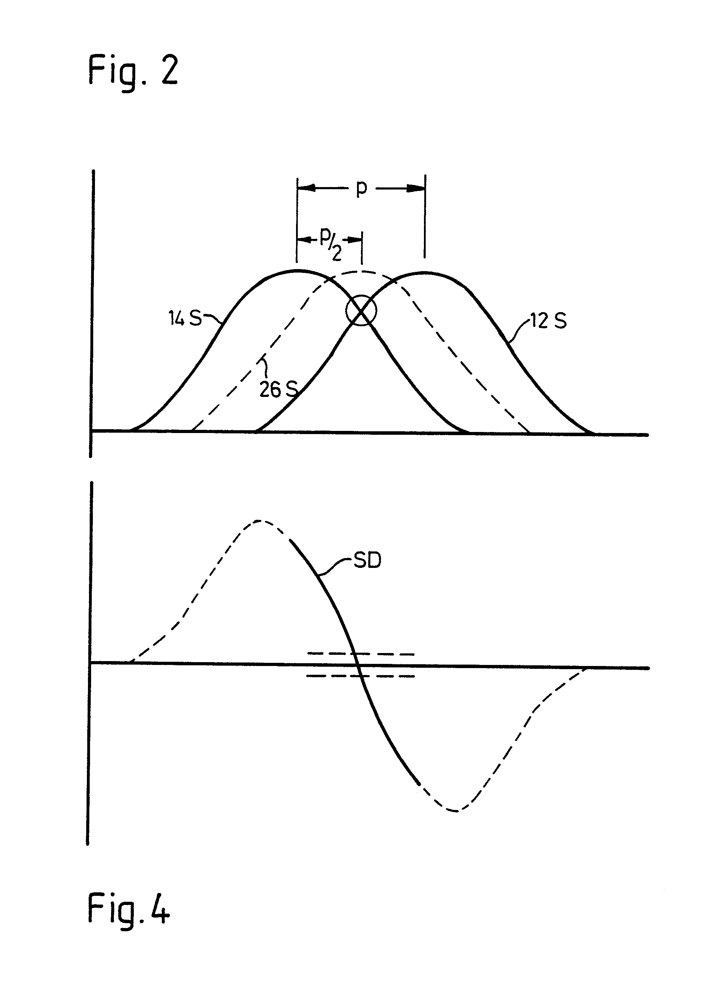

Assume firstly that the object passes by magnet 10 in the direction DR without stopping. As shown in Fig. 2, in an idealised arrangement, as the object passes through the field of magnet 10, devices 12 and 14 will emit respective half-wave signals indicated at 12S and 14S respectively. That is, as device 14 enters the field, its signal level rises from zero, reaches a peak as device 14 passes the axis A and then declines again to zero as the device 14 leaves the influence of magnet 10. Signal 14S may have any suitable physical form. For example, in the data sheets supplied by Siemens AG in respect of the KSY 10 Position Hall Sensor, it is suggested that the sensor can be operated in a constant current mode, whereupon the output Hall voltage varies proportionally to the field strength of the magnetic field acting on the sensor.

The generation of signal 12S is similar with a phase delay p dependent upon the spacing d and the speed of movement of the object in the direction DR. If the spacing d is correctly chosen in relation to the spread of the magnetic field in the plane of the drawing, then the signal 14S is declining and signal 12S is rising when axis I coincides with axis A. Furthermore, if the field is ideally symmetrical and signal generation conditions are the same for both devices, then signals 12S and 14S will be equal at "perfect location". A location operation can therefore be performed by detect ing the balance condition of the signal outputs from devices 12 and 14.

In addition, an indication is required that the balance is achieved while these devices are subjected to the field of magnet 10, since a "balance" (in the sense of equal signal output) is also achieved when the object is completely outside the influence of the magnet. Arrangements for indicating the influence of the magnetic field on devices 12 and 14 will be further referred to below in discussion of practical embodiments.

RELATIONSHIP TO THE PRIOR APPLICATION

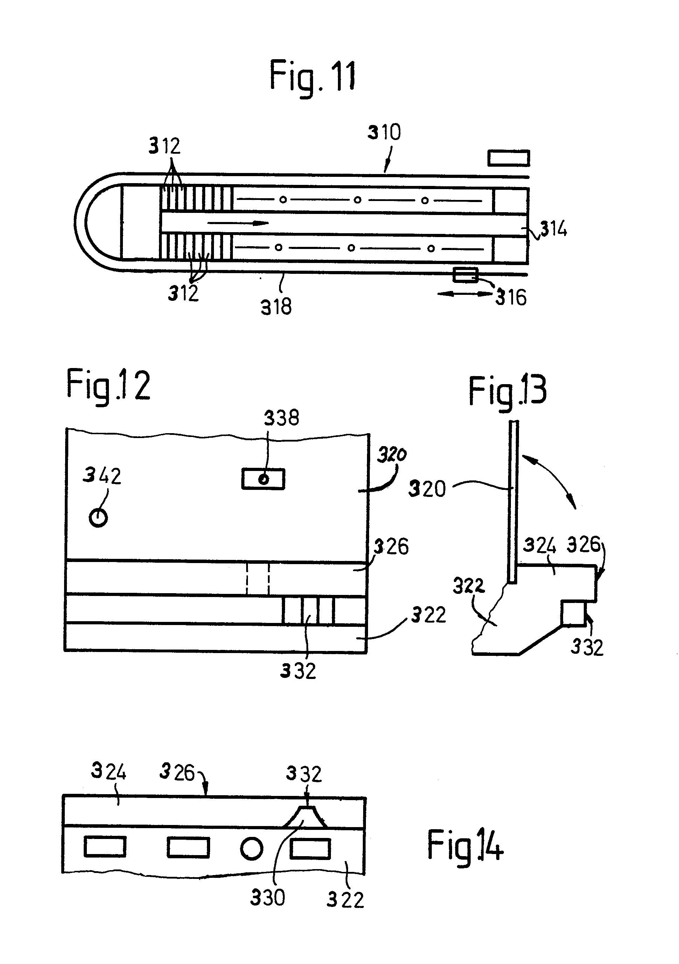

Although the full disclosure of the prior application is incorporated in this specification by reference, certain particularly relevant parts of that disclosure will now be summarised with reference to Figures 11 to 17.

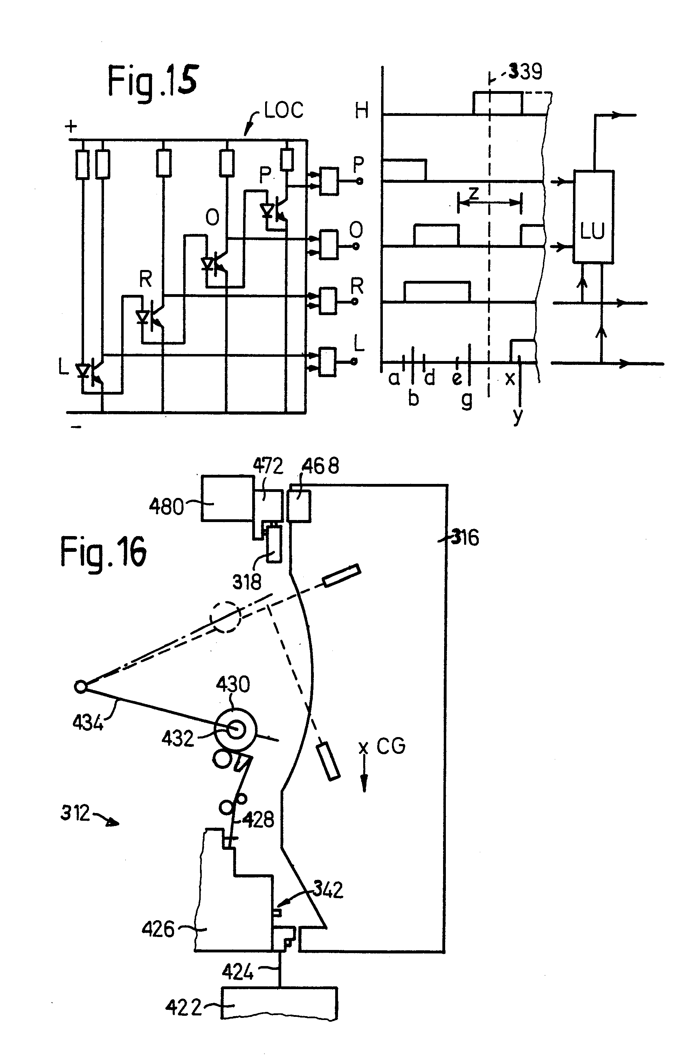

Open end spinning machine 310 shown in Fig. 11 is an elongated structure having two rows of spinning stations 312 ranged on opposite sides of the machine. It is current conventional practice to provide approximately 100 spinning stations per machine side. The stations are designed to operate independently of one another. As shown diagrammatically in Fig. 16, each station comprises a spinning unit 426 receiving its own feed of fibre material 424 from a can 422 and processing its feed to produce a yarn 428 which is wound into a package 430 on a bobbin tube 432 carried by a cradle 434. When the package at a particular station reaches a substantially predetermined length, the spinning operation at that station can be stopped and a package can be "doffed". In this doffing operation, the package is removed from its supporting cradle in the spinning station and is transferred to a conveyor 314 (Fig. 11) which runs along the centre of the machine and transfers the package to one end thereof. A fresh bobbin tube can then be mounted in the cradle, and the spinning operation at that station can be restarted.

If the thread at a particular station breaks before completion of winding of a package of the required length, a piecing operation must be carried out. Even without occurrence of such a break, however, it is good practice to carry out "preventive maintenance" involving interruption of the spinning operation after a predetermined operating period, even though that operation is currently performing satisfactorily, and cleaning of the spinning unit. Following such a preventive maintenance operation, a normal piecing operation must be carried out because of the intentional thread break caused by the interruption.

A service tender for performing one or more of these operations is indicated schematically at 316 in Fig. 11 and Fig. 16. It is suspended from carrier beam 468 (Fig. 16) supported by wheel assemblies 472 on a U-shaped rail extending along both sides and around one end of the machine 310. The tender is driven along the rail by motor 480.

The illustrated tender 316 patrols back and forth from one end of its rail 318 to the other until it detects a "disturbance" at one station; it will then stop and perform an appropriate operation at that station. The "disturbance" may be completion of a package, an undesired thread break or interruption of spinning because preventive maintenance is due. A signalling system for indicating the disturbance to the tender is described in the prior application. Whichever operation is to be performed, however, the tender 316 must locate accurately relative to the appropriate station.

Fig. 12 shows in elevation the front face of one spinning unit 426 (Fig. 16). A face plate 320 is secured by any suitable means (not shown) to a carrier portion 322 secured by a suitable mounting (not shown) in the structure of the unit 426. Carrier 322 also supports a rail element 324 extending longitudinally of the machine and presenting a surface 326 disposed in a vertical plane as seen in Fig. 13. Surfaces 326 provide a guide for one or more rollers (not shown) provided on the tender 316 and serving to support the tender against any tendency to swing on its suspension from rail 318.

Adjacent one end of element 324, and integral therewith, is a forward projection 330. As best seen in Fig. 14, element 330 is triangular in plan, but the "peak" of the triangle is flattened and the resulting surface 332 is disposed inwardly (with regard to the machine 310) of the guide surface 326.

Fig. 12 also shows the sliver inlet 338 through which fibre sliver is fed into the interior of the spinning unit in use. Numeral 342 in Fig. 12 indicates a signal lamp indicating a "disturbance" in a spinning unit. The tender 316 is arranged to respond to this lamp.

In the prior application, a profile sensor (not shown) was adapted to cooperate with projection 330, which functioned as a locating element or "marker". The profile sensor included a rotatable indicator element and photo detectors were provided in a device LOC for sensing the disposition of the rotatable indicator. Fig. 15 is a circuit diagram of the device LOC, showing also possible signal outputs from this device during a locating operation and means for processing such outputs to provide signals controlling operation of motor 480. Each photo detector of the locating device comprises a light emitting diode, associated with a respective photo transistor, the output of which is taken via a suitable buffer stage to respective output terminals indicated by reference letters L, R, O, P corresponding with the references indicating the detectors. In order to illustrate the principles involved, reference will be made to signals made up of "high" and "low" conditions at the terminals P, O, R and L. It will be understood that this is purely by way of example; the form of each signal will in practice depend upon the type of circuitry used to process it.

Assume that the locating device is approaching a locating element 330 upon which the tender is to locate. The rotatable indicator (not shown) is in a "normal" position because contact has not been made with the locating element. In the signal diagram in Fig. 15, these conditions are represented at the vertical axis; terminal P is high and terminals O, R and L are all low.

At point a, contact is made with one side face of the relevant locating element, and the indicator is pivoted away from its normal position in a sense dependent upon the direction of relative movement of device LOC and element 330. Assume the tender is moving towards the right; continued movement in the same direction is required, so that the output at terminal R goes high, the conditions of the other terminals remaining unchanged. At point b, the output at terminal O goes high. At point d, the tender has reached a position in which the profile sensor has been pushed slightly backwards towards the tender 316 due to its contact with profile 330. The output at terminal P goes low.

After passing the "peak" of the profile, the rotatable indicator begins to return towards its normal position. At point e, it has returned sufficiently to change the state of the detector O so that the output at terminal O goes low. After a short delay, the output at terminal R goes low at point g.

Each of terminals P, O, R and L is connected to a logic unit LU which forms part of a control system for motor 480. As indicated on the upper part of the signal program in Fig 15, logic unit LU produces an output signal H when all of its inputs go low. In response to signal H, the motor control supplies a signal which causes motor 480 to bring the tender to a halt.

The points a, b, d, e, g correspond to predetermined relationships of the non-illustrated indicator to the photo detectors O, R and L. These relationships correspond in turn to predetermined dispositions of the locating device relative to the locating element 330. Accordingly, the points e and g correspond to predetermined tolerances in location of the tender 316 about a desired exact location represented in the signal diagram of Fig. 15 by the vertical dotted line 339. At point e, the tender is located within a desired maximum tolerance range from its exact position, and at point g the tender is located within a desired fine tolerance range from the exact position. The signal H is produced when the tender enters the fine tolerance range.

Assume now that the tender overruns the exact location by an amount sufficient to take it outside the defined maximum tolerances. The indicator therefore begins to pivot away from its normal position in a direction opposite to its direction of pivot during the approach phase. At point x, i.e. when the tender leaves the fine tolerance range, output L goes high. After a delay, terminal O goes high at point y. The logic unit LU cancels signal H at point y, i.e. when the tender leaves the maximum tolerance range.

The control system responds to the cancellation of the signal H to restart operation of the motor to drive the tender back towards the desired location. The required direction of rotation of the motor for this purpose is indicated by the conditions of the terminals R and L, the latter being high and the former low. When the tender reenters the maximum tolerance range, terminal O again goes low, and when the tender enters the fine tolerance range, terminal L goes low. The signal H is again produced by logic unit LU and the motor again brings the tender to a halt. The tender should now remain within the fine tolerance range, and the signal H is produced continuously so that the tender remains stationary. If the tender does not overrun the desired location following its first approach, then the signal H will be continuous after the point g as indicated by the dotted line continuation of the signal H shown in Fig. 15.

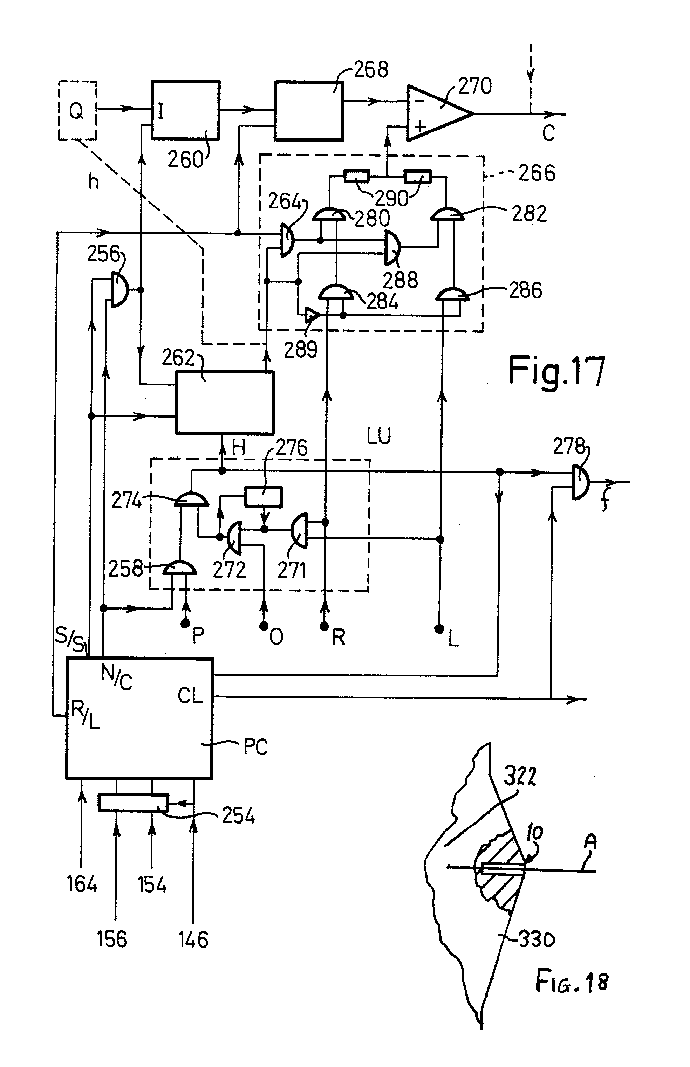

Fig. 17 is a highly simplified circuit diagram of part of the motor control system, showing a programmable controller PC and a unit, including logic unit LU, for generating a motor control signal C. The controller receives an input at 446 from a detector (not shown) which responds to the signal lamp 342 at the individual spinning stations. Controller PC also receives inputs, a few only have been shown at 454, 456 and 464, indicating conditions at the spinning stations, on the tender and elsewhere.

Three outputs from the controller PC are passed to the control signal generating unit, called the "setpoint unit SP". The first output S/S simply represents a main on/off switch so that the setpoint unit is enabled or disabled depending upon signals it receives upon output S/S.

The output R/L indicates whether the tender is to travel to the right or to the left in its normal - (patrolling) run, i.e. before receiving a call signal requiring it to locate relative to a particular spinning station. The condition of this output may be dependent upon trip switches responsive to the rail ends.

Output N/C indicates whether the tender is to travel at normal (patrolling) speed or at crawl speed (for a location operation). If a call signal appears on the input from detector 446, and a "valid" combination of other inputs is obtained, then the controller changes the conditions of its output N/C to indicate the requirement to brake the tender from its running (or normal) speed to its crawling speed.

Output N/C is connected to a gate 258 which forms part of the logic unit LU described with reference to Fig. 15. Gate 258, which receives a second input from the detector P in the locating device LOC (Fig. 15), is blocked unless controller output N/C indicates that the tender is moving at its crawling speed or is being braked towards that speed.

The "normal running" signal from controller PC is fed to a counter 260, the output of which is fed to a digital-to-analog converter 268. The latter also receives an input from the R/L output of controller PC. The output of converter 268 is fed to one input of an operational amplifier 270.

The output N/C is also connected to a bistable device 262, the instantaneous state of which is dependent in part upon signals it receives from output N/C and in part upon signal H from logic unit LU. The output of device 262 is fed to, and determines the condition of, a logic decision device indicated as a unit by the dotted line box 266.

Device 266 receives additional inputs from the R/L output of controller PC, and from the R and L terminals of the locating device LOC. As will be described further below, device 266 responds either to the right/left information it receives from controller PC or to the right/left information from device LOC, but not to both. The current state of device 262 determines which set of right/left information is effective, the device 262 being set to select the information supplied on the R/L output of controller PC during normal running.

The output of device 266 is fed to a second input of the operational amplifier 270. The output of amplifier 270 is the required control signal c.

Deviation signals representing required performance of the motor 480 (Fig. 16) during normal running and braking are supplied to amplifier 270 on its input from converter 268. Deviation signals representing required performance of the motor 480 during the crawling phase and during the final stages of location of the tender on a locating element 330 (Fig. 14) are supplied to the amplifier 270 on its input from the logic device 266. Each deviation signal must comprise both a magnitude aspect indicating the required speed of the tender and a direction aspect indicating the required direction of travel of the tender.

When counter 260 receives the normal running signal from controller PC, the counter supplies a predetermined signal in digital form to the converter 268. This predetermined signal represents a maximum magnitude for the signal to be supplied to amplifier 270. The "sense" of the signal appearing on the output of the converter 268 is determined by the current condition of the output R/L of the controller PC.

When a brake signal appears on the output N/C of the controller PC, there is no immediate change in the condition of the bistable device 262, but counter 260 begins to count down from its preset maximum value, and the magnitude aspect of the output from converter 268 is correspondingly reduced. The direction aspect remains the same as determined by output R/L of controller PC.

When the output of converter 268 goes to zero, the output of amplifier 270 will be determined as to both magnitude and sense by the logic device 266, which will be supplying to the amplifier a signal of a predetermined magnitude representing the desired crawling speed and a sense dependent upon the current condition of the output R/L of the controller PC. Since this is unchanged during the approach phase, the tender continues in its original direction of movement but at substantially reduced speed as described above.

Meanwhile, the change of output N/C has removed the block on gate 258 imposed by controller PC. However, gate 258 is still blocked during the braking phase and immediately thereafter because the output of photo detector P is then high. Blocking of gate 258 also blocks gate 274. When the output of detector P first goes low (Fig. 15) to unblock gate 258, the output of either detector R or L will be high (as described above with reference to Fig. 15), and gates 271, 272 will respond to hold gate 274 blocked. However, when the outputs of all four detectors P, O, R and L go low, gate 274 will be operated to provide the signal H to the bistable device 262 and also via a suitable buffer stage (not shown) to the controller PC.

Detectors O, R and L are used to define both fine tolerances and maximum tolerances. In order to maintain the signal H even after one of the detectors R and L indicates a shift of the tender outside the fine tolerance range while remaining within the maximum tolerances, the output of gate 272 is fed back via a suitable element 276 to the gate input which is connected to gate 271. If signal H is maintained over a predetermined minimum period, controller PC supplies an output signal on its output CL to an operating device (not shown) to secure the tender in the required location.

As soon as signal H appears on the output from gate 274, bistable device 262 changes state and changes the output it supplies to device 266. This change of state of device 262 is irrevocable until device 262 receives a reset input from output N/C, i.e. device 262 will not respond further to cancellation of signal H on gate 274 due to overrunning of the locating element 330. Accordingly, as soon as the tender has reached the desired location from its original direction of approach, a device 262 is re-conditioned so that any further signal supplied by the logic device 266 is independent of the current state of the output R/L of the controller PC but is dependent upon inputs which the logic device receives from the photo detectors R and L. It follows that the latter detectors have no effect upon the amplifier 270 during the approach phase; however, the direction of movement of the tender after it has once passed through the desired location can be controlled only by the states of the outputs of the detectors R and L.

Device 266 will not be described in detail here. The amplifier 270 is connected to a suitable tapping point on the device 266. The potential at the tapping point can be driven into any one of three predetermined conditions representing respectively "travel to the right at crawl speed", "travel to the left at crawl speed" and "neutral". The latter condition is created when both inputs R and L are low.

Returning now to the modifications proposed by the present invention, the magnet 10 (Fig. 1) replaces (functionally) the profiles 330 shown in Fig. 12 to 14. Thus, each individual operating station of the machine shown in Fig. 11 must be provided with its own individual magnet (location marker). In a physical arrangement, the profile 330 could be retained with the magnet 10 set into the surface 332 thereof with the axis A extending at right angles to that surface. The field created by each locating magnet thus projects into the space immediately in front of its associated operating station.

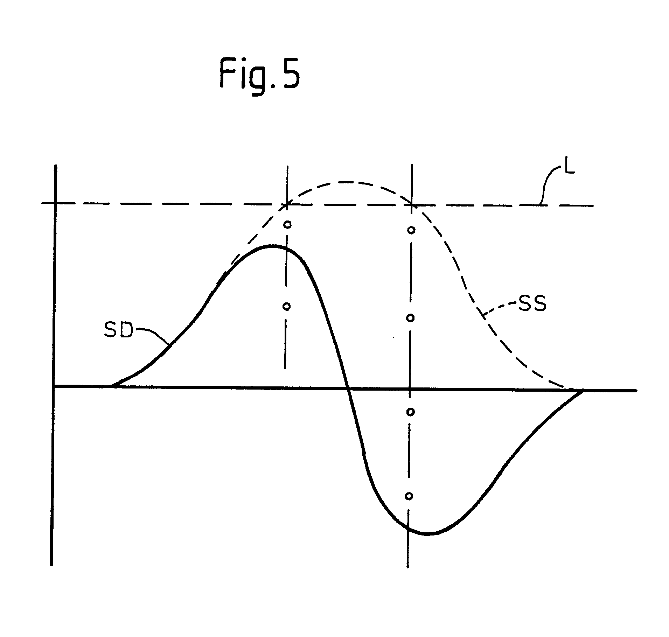

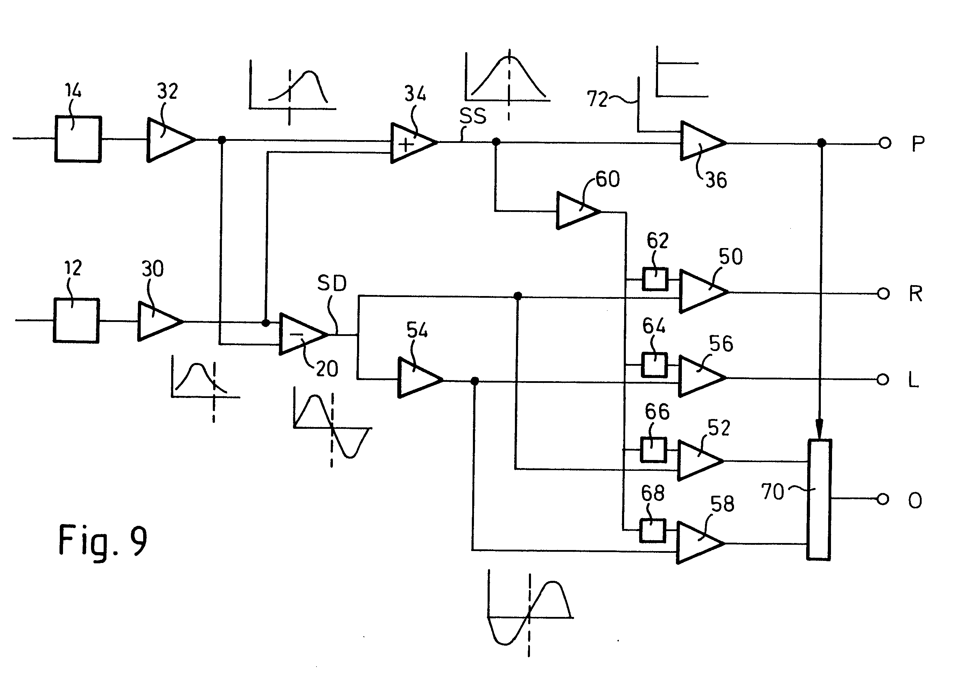

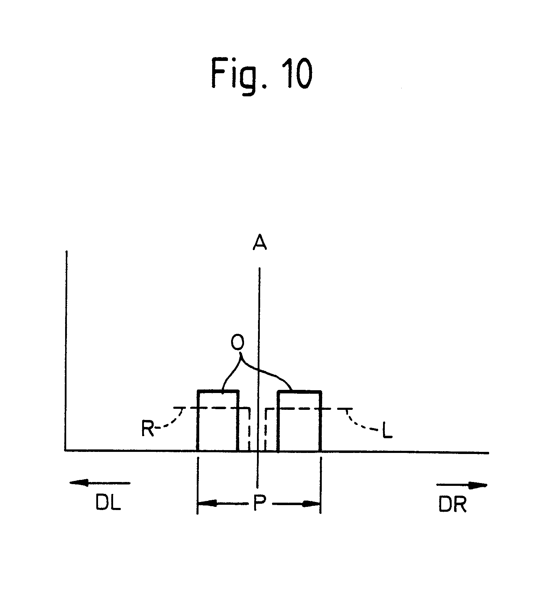

The devices 12 and 14 shown in Fig. 1 replace the profile sensor (contact rollers 84, 86 and indicator 80 shown in Fig. 5, 6 and 7 of the prior application). As will be apparent from Fig. 1, the locating apparatus now contemplated is a non-constant system, the devices 12, 14 being influenced by the magnetic fields created by the locating magnets. Accordingly, there is no movement of the devices 12, 14 in directions along the axis A of magnet 10 corresponding to the backward shift of the profile sensor (as indicated at m in Figs. 4 A to 4 C in the prior application). Accordingly, there is no direct equivalent of the photocell P shown in Fig. 15. In the system described in the prior application, the output of photocell P was used as a positive indication that contact had been made between the profile and the profile sensor; a corresponding function (an indication that devices 12, 14 in Fig. 1 are subjected to the influence of the field of magnet 10) is required also in the new system, and an alternative means for providing such an indication will be described later in this specification. The photocell O shown in Fig. 5 of the prior application and in Fig. 15 of this application was provided in order to enable definition of both coarse and fine tolerance ranges; an arrangement permitting definition of such dual ranges will be described with reference to Figs. 9 and 10, but there is no equivalent in the arrangements shown in Figs. 3 to 8.

In the prior arrangement, shown in Fig. 15, a centre detection function is performed by logic unit LU, which issues signal H when the tender enters the fine tolerance zone. An arrangement for performing this centre detection function using devices 12, 14 will now be described with reference to Figs. 3 and 4.

Fig. 3 again indicates the devices 12 and 14 together with respective signal outputs 16, 18 therefrom. These signals are fed to a difference generator 20 (for example as described on page 3 -180 of the 1982 Edition of the Linear Databook issued by National Semiconductor Corp. of Santa Clara, California, USA, under the name "High Input Z Adjustable-Gain DC Instrumentation Amplifier").

Generator 20 generates a signal SD (Fig. 4) representing the instantaneous difference generated by combining signal 14S with the inversion of signal 12S. As shown by the relationship between Figs. 2 and 4, in the idealised system this difference signal SD is zero at perfect location. The difference signal SD from generator 20 is passed via a gate 22 (further described below) to a zero point detector 24. When the difference signal fed to detector 24 passes through zero, the detector is arranged to produce an output signal H. This signal is the functional equivalent of the signal H shown in Fig. 15 and in Fig. 17. Thus, as indicated by the dotted rectangle in Fig. 3, the elements 20, 22, 24 together form a logic unit LU which in its centre indicating capability is the functional equivalent of the logic unit LU shown in Figs. 15 and 17. For centre detection, however, an additional input - (corresponding to input P in Fig. 17) is required to gate 22.

One means of providing such an additional input, in the form of additional Hall device 26, is indicated in dotted lines in Fig. 1 and Fig. 3. As shown in Fig. 1, this additional device is located midway between devices 12 and 14. As shown in Fig. 2 by the dotted line half-wave 26S, the output of device 26 is similar in form to the outputs of devices 12 and 14, and has a phase shift $\frac{P}{2}$ relative to the signal 14S. The signal 26S can be fed as a control input to the gate 22 (Fig. 3) so that a difference signal SD from difference generator 20 is fed to the detector 24 only if device 26 indicates that the object is located within the field of a locating magnet 10. Depending upon the characteristics of gate 22, detector 24 can be arranged to receive, for example, the full line portion of signal SD, but not the dotted line portion thereof. Clearly, when the object is totally outside the range of influence of the field of magnet 10, no signal will be passed to detector 24, although the outputs of devices 12, 14 are then "balanced", that is both zero.

Instead of detecting the zero crossing point of the signal SD, detector 24 may be arranged to detect that the signal SD lies within certain threshold limits above and below the zero level, as indicated by the dotted lines parallel to the horizontal axis in Fig. 4. In Fig. 2, this "tolerance zone" is represented by the circle around the intersection of the signal wave-forms 14S and 12S. Detector 24 may be arranged to produce the signal H when the axis I (Fig. 1) enters the tolerance zone, and to cancel the signal H when the axis I leaves the tolerance zone.

The arrangement is not limited to the use of Hall devices. For example, magnetic flux sensitive resistors can be used in essentially the same way, although the detailed arrangements for producing the signals 12S and 14S may then be different. Such arrangements can be established in accordance with standard principles of electronic circuitry design and will not be dealt with in this specification.

It will be realised that the arrangement illustrated in Figs. 1 to 4 has been described by way of example only with reference to the direction of movement DR. The principle is exactly the same for direction DL, but account must be taken of the fact that signal 12S now leads signal 14S (instead of lagging as shown in Fig. 2). If difference generator 20 comprises a "positive" input (fed by element 14 in the illustrated example) and a "negative" input (fed by element 12), then signal SD will be inverted (relative to Fig. 4) when the object moves in direction DL. For centre detection, where only the zero crossing is significant, this inversion has no practical effect.

PREFERRED EMBODIMENTS

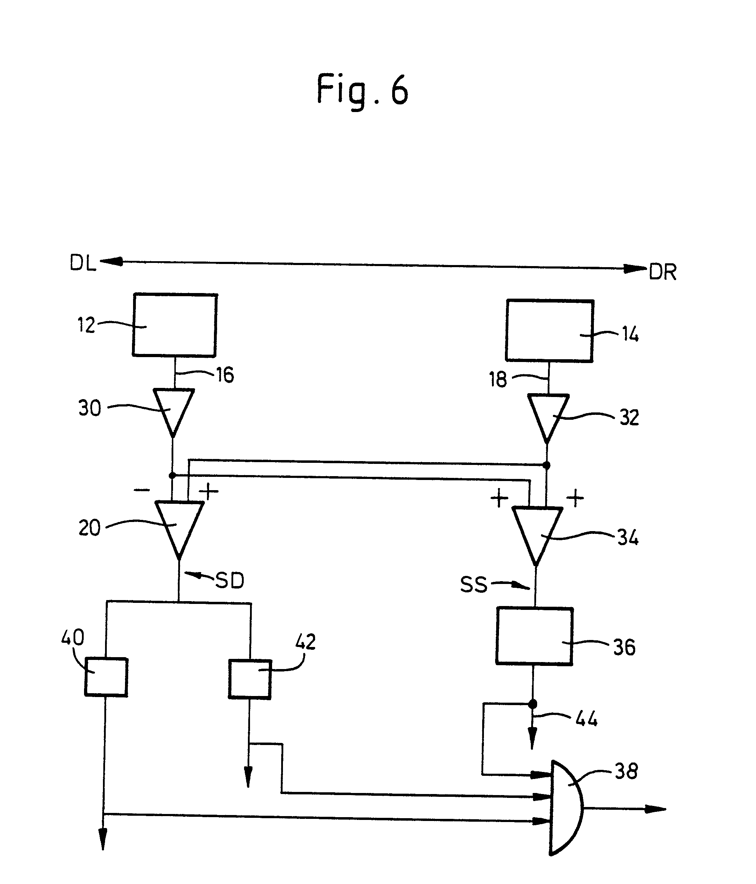

The arrangement shown in dotted lines in Figs. 1 and 3 requires the inclusion of a third field-sensitive element for centre detection. As will be shown by reference to the alternative signal pattern illustrated in Fig. 5, the third element is not necessary -the additional signal required to confirm the influence of the magnet 10 can be derived from the outputs of elements 12 and 14. For this purpose, an alternative signal processing circuit is required, as shown in Fig. 6.

Furthermore, the arrangement as described with reference to Fig. 3 provides only centre detection. In practice, unless acceptable relative location is achieved in the first approach, the system is preferably also adapted to provide right/left indications as described with reference to Figs. 15 and 17 for the prior mechanical contact system.

The circuit shown in Fig. 6 is adapted to provide such indications. As in the prior application, it is emphasised that the expressions "right" and "left" are (in this context) arbitrary but convenient designations indicating opposite directions of movement (DL and DR) of the movable object along a predetermined track.

Referring first to Fig. 5, the difference signal SD representing the difference between the ouputs of devices 12 and 14, as shown in full lines. A summation signal SS, representing the sum of the outputs of devices 12 and 14, is shown in dotted lines. In the idealised arrangement, signal SS passes through a peak at the instant signal SD passes through zero; in this respect signal SS resembles signal 26S shown in Fig. 2. The portion of signal SS to either side of the peak (i.e. the portion of signal SS differing substantially from both signal 12S and 14S) can perform the same function as signal 26S previously described. The derivation and use of signal SS will now be described with reference to Fig. 6, where elements 12 and 14 are shown again with their respective outputs 16 and 18.

Outputs 16 and 18 lead to respective buffer amplifiers (so-called "instrumentation amplifiers") 30, 32. These provide suitable signals to the difference amplifier 20 (as already described with reference to Fig. 3) and to summing amplifier 34 which provides signal SS on its output. Signal SS is fed to a threshold device 36 which blocks passage of signals below a predetermined level indicated diagrammatically by the horizontal line L in Fig. 5. Any signal passing beyond device 36 is fed to a logic gate 38 similar to gate 22 previously described. The exact operation of gate 38 will be further described later; for the present, it is sufficient to state that the gate is blocked unless a signal is received from device 36.

As seen by reference to Fig. 5, threshold L permits only the peak region of signal SS to pass through to gate 38. Thus gate 38 is "open" only for the portion of signal SD lying between the vertical chain dotted lines in Fig. 5 including, of course, the zero crossing point.

Consider now the derivation of "right" and "left" indications. As an arbitrary convention, "right" refers to a direction of movement (DR) in which element 14 is leading and "left" refers to the opposite direction of movement (DL) in which element 12 is leading. As also indicated in Fig. 6, amplifier 20 is of the type having a positive input - (fed by amplifier 32) and a negative input (fed by amplifier 30). The difference signal SD is formed by summing the "positive" and "negative" inputs and is passed to each of two devices indicated at 40, 42 respectively.

Device 40 is adapted to pass, for example, the positive portion of signal SD and to block the negative portion; the latter is passed by device 42 which blocks the positive portion. Taken together, the outputs of devices 40, 42 provide the complete difference signal SD, but only one device at a time is actually providing an output signal. The outputs of both devices 40, 42 are fed to gate 38 and are passed by that gate when it is receiving an appropriate signal from threshold device 36 as described above. The output of gate 38 can therefore be passed to a zero-crossing detector as described with reference to Fig. 3. Devices 40 and 42 are preferably analog/digital convertors, so that the signals fed to gate 38 are in digital form. Each of devices 36, 40 and 42 may be a so-called Schmidt-trigger circuit.

A signal on the output from device 40 indicates that the field of magnet 10 is effective predominantly on element 14; in accordance with the defined convention, further movement to the right (direction DR) is required to achieve perfect location. Device 40 may be designated the "right selector". A signal on the out put from device 42 (the "left selector") indicates that movement to the left - (direction DL) is required.

Thus, the arrangement shown in Fig. 6 provides a centre detection signal H and "left" and "right" signals on outputs L, R; it can therefore be substituted for unit LU shown in Fig. 17, with slight additional modification to make generation of signal H dependent upon the condition of output N/C of controller PC (if desired). There is, however, a difference in operation which must also be taken into account.

In the circuit of Fig. 17, transfer of control of movement of the object (service tender) from a "normal" operating system to the right/left signal generator of the locating system was effected by bistable device 262 only after the object reached or passed through perfect location on its first approach (i.e. in response to first generation of the signal H). In the system illustrated in Fig. 6, transfer of control to the right/left selectors 40, 42 is effected in response to generation of a "gate unblocking" signal at the output of threshold device 36. The gate unblocking signal may be passed as an "enabling" signal on line 44 (Fig. 6) to the bistable device 262 (Fig. 17), so that the drive control thereafter responds to direction signals on the outputs from devices 40 and 42. Thus, transfer of control is effected during the approach to perfect location, when the locating apparatus indicates that it can generate usable locating signals based on the marker field. Bistable device 262 no longer receives the signal H, which is generated after control of movement has passed to device 266.

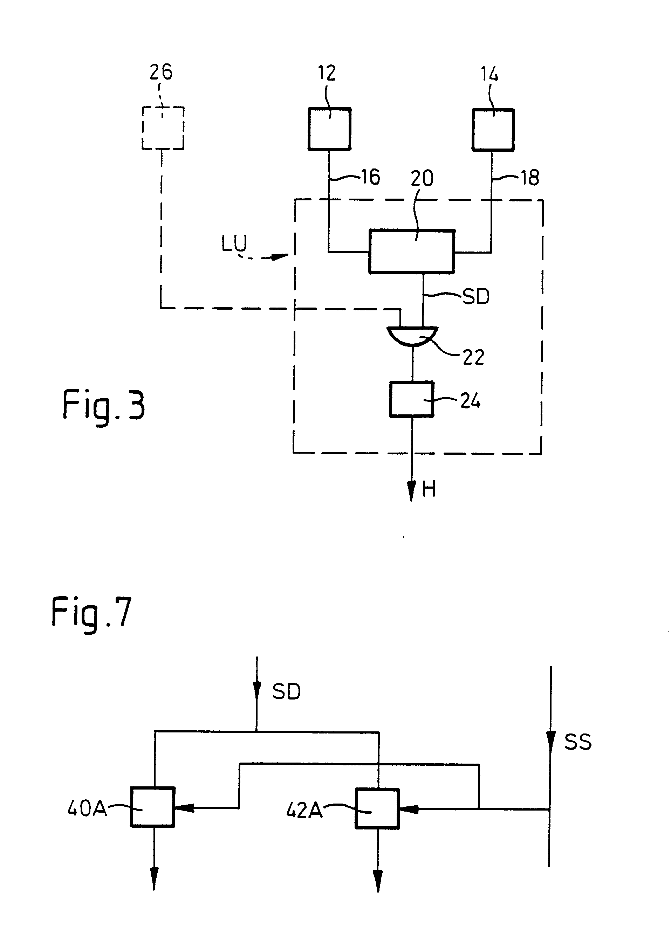

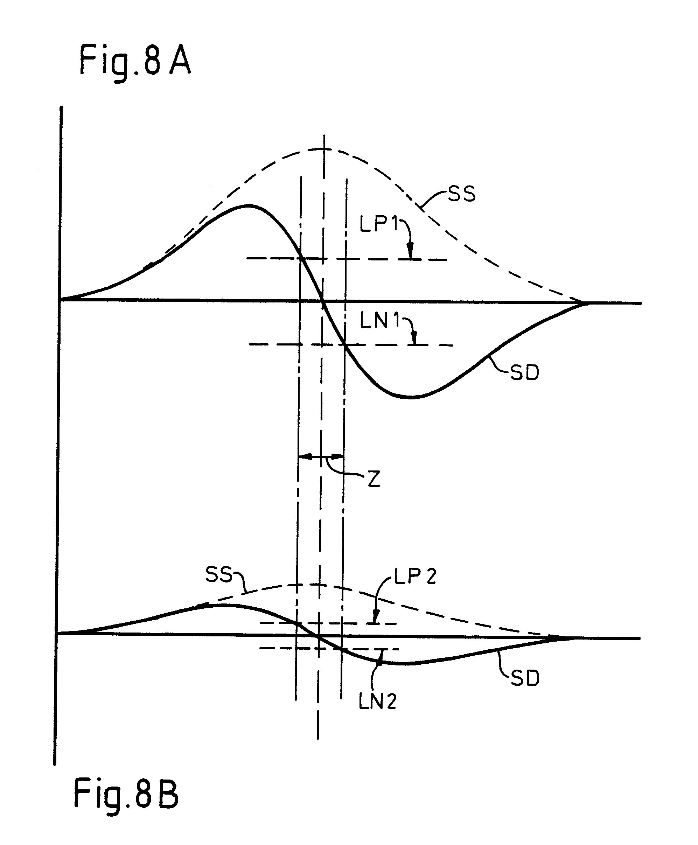

Figs. 7 and 8 illustrate an arrangement for compensating signal magnitude effects caused by variation, for example, in spacing of the devices 12, 14 from magnets 10 in the direction of axis A.

Consider first the diagrams in Fig. 8A and Fig. 8B. The upper diagram (8A) shows signals SD and SS where the spacing between magnet 10 and elements 12, 14 (along axis A) is at a minimum - corresponding to maximum field strength on the relevant path DL, DR and hence maximum output signal level from the elements. The lower diagram - (8B) shows the signal SD and SS where the spacing is at a maximum -corresponding to minimum field strength and output signal level. In both cases, the difference signal SD is fed to modified right and left selectors 40A, 42A (Fig. 7) respectively, which now include a threshold defining function in addition to their previously described polarity selection functions.

The threshold defined by device 40A is indicated at LP1 in Fig. 8A and LP2 in Fig. 8B. The threshold defined by device 42A is indicated at LN1 in Fig. 8A and LN2 in Fig. 8B. As indicated by the vertical dotted lines joining Figs. 8A and 8B, the "bandwidth" Z of the portion of signal SD selected between the threshold limits LP1, LN1 is the same as the bandwidth of the portion of signal SD selected between threshold limits LP2, LN2. Also, the band Z is symmetrically disposed around the zero crossing (perfect location) in both cases. In order to achieve this, the thresholds defined by devices 40A and 42A must be variable in dependence upon the signal strength.

The required variability of he threshold levels can be obtained by making them dependent upon the level of the summation signal SS, as indicated by the interconnections shown in Fig. 7.

Although the circuits shown in Figs. 6 to 8 can be incorporated in a control system according to Fig. 17, it may be desirable to have a detector unit which can be simply substituted for the unit shown in Fig. 15, the interconnections with the circuitry of Fig. 17 being maintained. A suitable arrangement is shown in Figs. 9 and 10.

The Hall elements 12, 14 are shown again in Fig. 9, which includes many components already described with reference to Figs. 6 and 7. In particular, the gain adjusting amplifiers 30 and 32, differential amplifier 20 and summing amplifier 34 have already been dealt with in description of Fig. 6, and will not be discussed again in any detail with reference to Fig. 9. The circuit arrangement following the amplifiers 20 and 34 has, however, been modified, and accordingly new reference symbols are applied to the remaining circuit elements.

The output SD of amplifier 20 is fed directly to two comparators 50 and 52 respectively and also to an inverter 54. The output of the latter is fed to two further comparators 56 and 58 respectively.

The output SS of amplifier 34 is fed to a comparator 36 and also to a level adjusting device 60, which modifies the signal level in a non-linear manner which will be further discussed below. The output of the level adjuster is passed to a first pair of threshold defining devices 62, 64 respectively, which define equal threshold levels for the comparators 50, 56 respectively, and also to a second pair of threshold devices 66, 68 respectively which define equal threshold levels for the comparators 52, 58 respectively. The threshold defined by the first pair is different to that defined by the second.

The outputs of comparators 52 and 58 are supplied to a gate device 70, which also receives an input from comparator 36. As indicated at the right hand side of Fig. 9, the circuit provides four signal outputs marked P, R, L and O respectively; these outputs correspond with the similarly marked outputs and inputs in Figs. 15 and 17. Thus, output P derived from comparator 36 indicates that the apparatus is in working cooperation with a "marker" represented in this case by the magnet 10 in Fig. 1; output R from comparator 50 and output L from comparator 56 provide signals indicating displacement of the apparatus to the right or left respectively of the desired position (the term "right" and "left" again being arbitrary indications of a required direction of travel to bring the apparatus into the desired position); and output O from gate 70 provides an indication that the apparatus is within a defined "coarse tolerance" range around the desired position.

Signals on the four outputs P, R, L and O in Fig. 9 can be processed by the control system for the moving means in exactly the same way as signals on the correspondingly identified outputs in Figs. 15 and 17. Accordingly, such processing will not be described again here, but the generation of the required signals on outputs P, R, L and O will be further discussed below.

Output P is generated by comparing the sum signal SS with a predetermined threshold signal input applied to line 72 in Fig. 9. The threshold level must be determined by reference to the known field strength of the marker magnet 10 and the usable part of that field as determined by the performance of the Hall elements.

Output R is generated by comparing the signal SD with a threshold set by the non-linear device 60 in conjunction with the adjuster 62. The purpose of the general arrangement, in which the "right indicator" signal R is made dependent upon the sum signal SS, has been described with reference to Figs. 7 and 8 and will not be repeated here. The only difference in the present case lies in the introduction of the non-linear function provided by element 60. This compensates for non-linear variation of the response of Hall elements 12 and 14 to changes in the spacing of devices 12, 14 from the end of the magnet along axis A in Fig. 1. The required non-linear function must be determined from case to case.

Output L is generated in the same way as output R except that the comparator operates upon the inversion of signal SD, and hence indicates the opposite required direction of travel.

Comparators 52 and 58 provide right and left indicating signals in the same way as comparators 50 and 56. The difference here is determined by the different adjustment set by devices 66, 68 as compared to that set by devices 62, 64. As will be shown by reference to the signal diagram in Fig. 10, the R and L outputs enable definition of "fine tolerances" around the desired position, while the output O (due to the different adjustment at 66, 68) defines coarse tolerances around that position.

In the diagram of Fig. 10, in which distance is represented on the horizontal axis and signal level on the vertical axis, the desired position is represented by the vertical line A (corresponding to the same line in Fig. 1). The signals provided by outputs L and R are indicated in dotted lines; it will be seen that these signals remote from the desired position are not defined by the system, but the signal changes close to the desired position are accurately set by the thresholds from devices 62 and 64.

The signals provided by output O are indicated in full lines. Here, the outermost edges of the "O" signals are set by the threshold effectively set by the "P" output; i.e., no output will be produced by gate O until output P indicates that effective cooperation with the magnet has been achieved . The inner signal edges are set by the adjusters 66 and 68 and they lie outside the inner signal edges of the R and L signals, thus defining a relatively coarse tolerance band about position A. The purpose of the dual tolerance limits is fully disclosed in European Application 126373.

The spacing of the elements 12, 14 along the path DR, DL must be selected in relation to the field pattern produced by the magnet 10 so that the desired signal pattern is produced as the Hall detector (comprising elements 12 and 14) passes by the magnet. Preferably, the signal level from the leading element 12 or 14 has fallen substantially below its peak level before the signal level from the trailing element reaches a significant value. Possible variations in the performance of the two elements, as compared with each other, can be compensated by adjustment of the variable gain amplifiers 30, 32.

As emphasised above, the arrangement shown in Fig. 9 enables direct replacement of the profile sensor of European Application 126373 by a Hall detector as now proposed. As in the arrangement shown in Fig. 17, therefore, transfer of direction control from the normal moving system to the locating system takes place when the detector reaches the desired position on its first approach. This is not essential however; the duel tolerances can also be applied where direction control is transferred to the detector as soon as the P output indicates a "usable field strength", as proposed above with reference to Fig. 6. This would, however, also require modification of the system showed in Fig. 17.

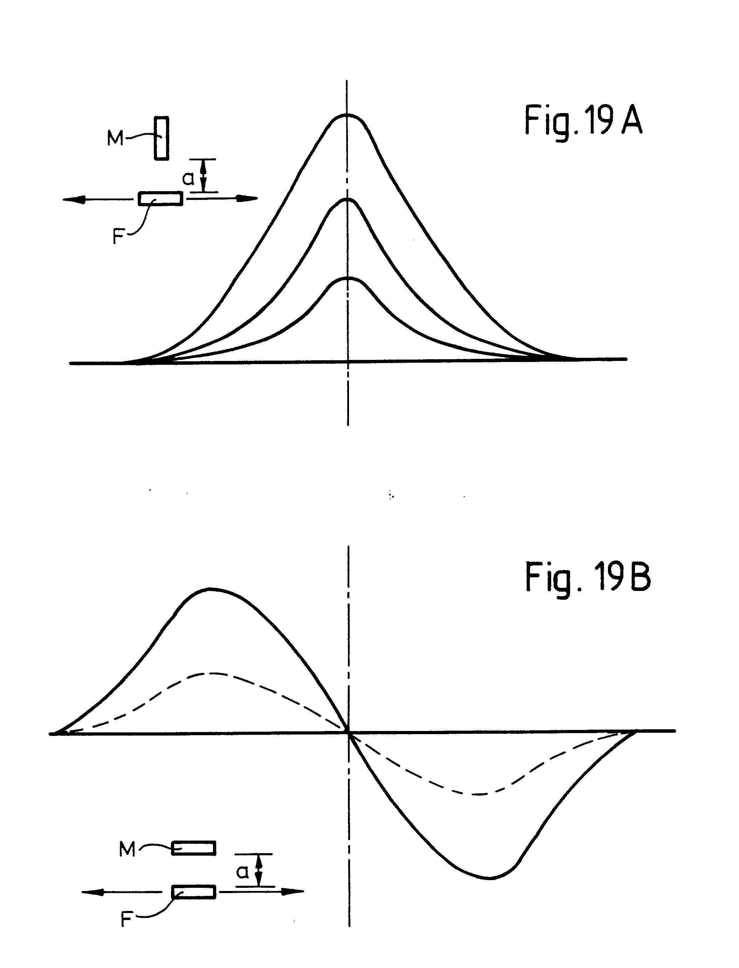

The interconnection of the P output with the outputs of comparators 52 and 58 by way of gate 70 represents a safety measure, since a similar function is performed in the circuit of Fig. 19 of European Application 126373, i.e., a change of state of the output of unit LU in the European Application is possible only when output P indicates adequate field strength due to cooperation with the "locating element" provided by marker magnet 10. This safety measure may be omitted if required.

## MODIFICATIONS

A selectively energisable magnet may be used in place of a permanent magnet. For example, an electromagnet selectively energisable with dc current could be used. The "marker" may then be energised only if the object is to be brought into alignment with it. For example, in terms of the system described in the prior application, the marker may be energised when a service tender is required to perform a service operation on a station associated with the marker. The resultant magnetic field is time invariant during the locating operation. When no service operation is required, the marker is left unenergised, no magnetic field is created and the marker has no effect upon the locating apparatus on the tender.

A selectively energisable marker magnet may also be energised by ac current, i.e. the magnetic field varies in time even during a location operation. When perfect location is achieved (in an idealised situa tion) the output signal from each field sensitive element 12, 14 is in the form of a waveform corresponding to that of the energising current. The waveforms have the same amplitude and the same phase delay relative to the energising current. They can therefore be balanced against each other to provide a null signal indicating perfect location -in practice, tolerance limits would be defined as already described above.

Hall elements are orientation-dependent elements, i.e. the Hall effect is dependent upon the disposition of a current flow relative to a magnetic field. The elements can be suitably disposed relative to the marker (magnet) to ensure generation of the desired signal pattern.

A major problem in design of equipment such as textile machinery using systems of the illustrated type is the maintenance of close tolerances in the spacing of the detector (pair of field sensitive elements) from the field generating element. The arrangement shown in Fig. 7, and the corresponding arrangement in Fig. 9, is therefore especially advantageous.

Thus, the means responsive to the states of the field sensitive elements, namely the signal processing devices provided by the amplifier 20 and devices 40, 42 (in Fig. 7) and devices 50, 52, 56, 58 (in Fig. 9) can be adapted to react to a selected signal or signals in a predetermined range of signal levels. This range may itself be variable (for example as shown in Figs. 8A and 8B between the range LN1 to LP1 and the range LN2 to LP2) in dependence upon signal level at the output from the field sensitive elements. The latter signal level may be represented by the peak or average or other suitable characteristic of a combined signal - (in the illustrated cases, the summation signal) derived from the outputs of the field sensitive elements. Means responsive to the selected characteristic (in the case illustrated in Fig. 9, the threshold defining means 62, 64, 66, 68) may be provided to adapt a means defining the required range of signal levels (in the case illustrated in Fig. 9, the devices 50, 52, 56, 58).

It will be apparent that this aspect of the invention is not limited to systems using magnetic fields -it is equally applicable, for example, to systems employing light fields (such as those described in US Patent Specification No. 3902308) or any other form of controllable, detectable field. Accordingly, the expression "field" where used in the claims is to be broadly construed unless expressly limited to magnetic fields.

Fig. 18 shows (in a partly sectioned underplan similar to Fig. 14) a simple variation of the spinning unit 426 to adapt it for use in a system according to the present invention. As shown, the profile 330 is retained, although it now functions simply as a support for the round bar magnet 10 which is embedded therein. The drawing is sectioned to show the magnet within the projection. The bar magnet may have a diameter of approximately 3 mm and a length of approximately 11 mm, being made of an Alnico alloy commonly used for pro duction of permanent magnets.

Mounting may be effected by boring a suitable receiving hole from the front face of projection 330, and securing the magnet bar in this hole by means of a suitable adhesive, e.g. a 2-component epoxy resin. The mounting step must be performed precisely because the longitudinal axis of the mounted magnet defines the "perfect location".

The bar is preferably mounted in an unmagnetised condition and is magnetised after the adhesive has set by means of a magnetising magnet which can be standardised to provide a locating field of predetermined flux density from each locating magnet treated thereby. Clearly the fields created by adjacent magnets should not interfere. A suitable flux density for use in a rotor spinning machine is approximately 0.018 Tesla. The Hall elements 12, 14 shown in Fig. 1 can then be spaced apart by a distance d of approximately 0.5 cms in the direction of travel of the tender. This will enable generation of unambiguous locating signals for each station individually.

In this specification, the expressions "difference signal" and "summation signal" have been used. The expression "difference signal" refers to a signal generated by combining the outputs of the field sensitive elements in such manner that they cancel each other to produce a zero crossing within the difference signal. Depending upon the relative phases of the outputs from the field sensitive elements, the cancellation may be achieved by addition or subtraction of the re levant outputs. The expression "summation signal" refers to a signal generated by combining the outputs of the field sensitive elements in such manner that they reinforce each other at the time at which the difference signal goes to zero.

## CONTEXT OF USE

The problem of achieving a desired accuracy of relative positioning of two relatively movable parts can arise under differing circumstances, which for present purposes can be classified as follows:

Type I -there is only one possible "desired" relative position of the parts, which must be adjusted from some undesired relative position until the "correct" condition (the desired relative position) is achieved.

Type II -there are many possible desired relative positions (any one of which can be "selected") and there are possible intermediate positions (which cannot be selected), i.e. gaps.

Type III -any one of a large number of possible desired relative positions can be selected and there are no (unselectable) intermediate positions (no gaps).

The distinction between Type II and Type III systems is dependent upon the accuracy of the positioning means. This becomes apparent when a positioning means relying upon markers is considered. When the spacing between the markers is significantly greater than the accuracy of the positioning means, the system is of Type II; if the spacing between the markers is of the same order as the accuracy of the positioning means, the system is of Type III.

The present invention in its overall concept is intended particularly for Type II situations. Certain detailed aspects of the invention can clearly be applied to Type I situations. The use of such detailed aspects of Type III situations is not excluded, but the overall concept is not designed for situations of that type.

## FORM OF MARKER

The invention requires a marker which generates a generally known field pattern in the space through which a locating apparatus (responsive to the marker field) will pass in use. The field pattern is preferably substantially symmetrical about a predetermined axis in a "plane of movement" of the apparatus.

Magnetic markers offer substantial advantages under these conditions. Permanent magnets can be manufactured relatively easily with closely defined geometrical forms and homogeneous material structures, and they can be controllably magnetised to give the desired field pattern which (barring accidents) will be main tained over a long period. Magnetisation can be effected after assembly (as described above) so that the magnet bodies can be readily handled in bulk prior to assembly. Electromagnets are likewise relatively easy to produce in controllable fashion.

Optical devices will usually require complex lens systems, and will be much more liable to random disturbance and long term deterioration. Sonic devices, and devices relying upon electrostatic fields, will also be more difficult to provide in a shielded (disturbance-resistant) form capable of giving a defined field pattern over a long period.

## MARKER FIELD

Apart from the need to provide a known field pattern, the marker is preferably also such that the "effective field" appears only in the immediate neighbourhood of the marker. In this context, the "effective field" depends upon the sensitivity of the locating apparatus which in turn may be determined not only by the sensitivity of the field-responsive element(s) themselves, but also by any signal threshold levels built into the apparatus. Assuming, for example, that the apparatus is designed to reject any signals below a predetermined level, then the "effective field" is that portion of the field capable of generating a signal in the apparatus above the predetermined level.

Concentration of each marker field in the immediate region of its own marker improves accuracy of the lo cation operation and avoids risk of interference/ambiguity due to interaction of adjacent marker fields. In terms of the cylindrical permanent magnets illustrated in the drawings, this implies that the spacing of adjacent markers - (effectively, the so-called "gauge" of the spinning stations) should be significantly greater than the length of each magnet. For example, a spacing between magnets ten times greater than the magnet length should prove adequate - the "stray" field generated by one marker in the immediate neighbourhood of the next marker should then be less than 1 % of the field strength generated by the one marker in its own effective region. Normally, in a spinning machine, it will be possible to separate the marker magnets by much more than ten times the magnet length.

Since the marker fields are "concentrated", the locating apparatus must be arranged to run as close as possible, without contact, to each marker in order to ensure that the apparatus passes through the effective field. In terms of the arrangement shown in Fig. 1, the spacing "a" between the "path" (DL, DR) of the apparatus and the adjacent end of the magnet should be less than or equal to the length of the magnet. As already indicated above, and as will be further explained below, this can cause problems where the spacing between the apparatus and the marker cannot be controlled within very close tolerances.

## FORM OF LOCATING APPARATUS

The preferred marker field is symmetrical at least in one plane -the apparatus is then preferably designed to detect the axis of symmetry to indicate the desired relative position. Alternative arrangements, relying for example upon an identifiable point in a known, but non-symmetrical, field, are conceivable but likely to be difficult to put into practice.

The illustrated embodiments of the locating apparatus rely upon two field sensitive elements, responding simultaneously to the field at different locations spaced along the path of relative movement, to identify the axis of symmetry. This is not strictly essential, as will now be described with reference to the diagrams in Fig. 19.

In relation to Fig. 19, the marker M may be assumed to be the same as that shown in Fig. 18, i.e., a cylindrical permanent magnet (a flat bar magnet lying in a plane containing the detector unit could perform the same function). The locating apparatus itself differs from those shown in the preceding figures in that only one Hall-element F - (or other field-sensitive element) responds to the field (at least at the time at which the desired position is achieved). The element F has a "flux collecting" surface and the signal output level is dependent upon the flux intersecting this surface at right angles. Magnet M has a magnetic axis (joining the North and South poles), which is assumed to coincide with the geometrical longitudinal axis of magnet M.

In the upper diagram, Fig. 19A, the length of the magnet M (i.e. the dimension of the magnet along a line joining the North and South magnetic poles) is assumed to lie at right angles to the flux collecting surface in the element F and also to the path of travel indicated by the arrows - (corresponding to path DL, DR in Fig. 1). This is also the arrangement assumed in Figures 1 to 9.

As the Hall-element moves past the magnet, the resulting output signal from the Hall-element has the form already shown in Fig. 2 -approximately a "bell curve". Fig. 19A emphasises two facts about this curve:

1. it is itself symmetrical about a determinate "axis" through the peak of the curve, but

2. the height of that peak is dependent upon the minimum spacing between the semiconductor layer and the adjacent end of the magnet -a small spacing gives a high peak, a large spacing gives a low peak.

It is therefore only possible to identify the required central axis (desired position) by reference to a set peak voltage (or range of peak voltages) if the spacing "a" between the element F and the magnet M can be held within very tight tolerances. In systems such as those described with reference to Figures 10 to 17, this is just not possible.

In the lower diagram, Fig. 19B, the length of the magnet M is assumed to lie parallel to the plane of the field-sensitive semiconductor layer in the Hall-element F, e.g. the magnet M has been rotated through 90° relative to the disposition assumed in Fig. 19A (as indicated) or the element F is rotated through 90° to dispose its flux collecting surface at right angles to the path (not shown). As the Hall-element moves past the magnet, it will give an output signal of the form shown in Fig. 19B -it is emphasised that this signal arises from a single element (it is not a "difference signal" as discussed with reference to Fig. 4). These signal forms can be seen from page 40 of the 1976/77 Data Book entitled "Magnetfeldabhängige Halbleiter", published by Siemens AG, Bereich Bauelemente, of Balanstrasse 73, 8000 München 80, FRG.

The zero crossing in Fig. 19B is relatively insensitive to variation in spacing "a" between the locating apparatus and the magnet (in this case the relevant spacing is at right angles to the length of the magnet). However, as previously discussed with reference to Fig. 4, the zero crossing is in itself ambiguous since it represents a "null" signal which is achieved when the Hall-element is not subjected to the magnetic field. Additionally, the problem is compounded in the case of the arrangement shown in Fig. 19B by the fact that the full signal ouput from element F as it moves past magnet M is more complex than that actually shown in the Figure and contains several zero crossings, which would have to be distinguished to enable definition of a desired position.

The use of a second field-sensitive element which also responds to the field when the desired position is reached enables the above identified problems to be solved as described with reference to the specific embodiments. Alternative approaches to solution of these problems will be outlined below by way of example only:

-in the arrangement of Fig. 19A, the actual field strength (signal strength) available from an individual magnet could be detected in a first step and the "peak" could be detected in a second step based upon the previously detected signal strength. This could be carried out, for example, by causing a single element to pass through the field on a first pass to detect signal strength and then to enter the field on a second pass in the reverse direction to detect the peak. Alternatively, a "field strength detector" element could be provided in advance of the "positioning" element so that the relevant field strength information is already available when the positioning element first enters the field.

-in the arrangement of Fig. 19B an additional indicator of an alternative type could be provided to distinguish the desired zero crossing from spurious null signals. The additional indicator needs only sufficient accuracy for this purpose of distinguishing null signals -accuracy of the location operation itself is provided by the selected zero crossing.

-the marker could be made more complex, for example it could be provided by a magnet pair instead of a single magnet. As shown on page 37 of the Siemens Data Book referred to above, this arrange ment can be designed to give a signal containing two positive-going peaks separated by a negative-going trough. This locating apparatus could be "enabled" by either peak and could be adapted to locate by reference to the immediately following trough.

-a single field-sensitive element may be "sandwiched" between field "collecting shoes" thus converting it into a differential element, for example as shown on page 36 of the Siemens Data Book and in West German Published Patent Application (Auslegeschrift) No. 1270111.

In any arrangement, the flux collecting or effective surface area of the or each positioning field-sensitive element is adapted to the dimensions of the effective field of the marker. The "effective surface area" of the element is the area intersected by the lines of magnetic flux which create the signal output. In particular, the effective surface area should be such that the relevant element is affected by only one marker field at a time.

PRACTICAL APPLICATIONS

The practical embodiments described with reference to Figures 6 and 9 have been designed for application to location of a movable carriage relative to fixed operating stations of a textile (yarn-handling) machine such as a spinning, winding or texturising machine. Equally, of course, these embodiments could be used for location of movable operating stations (or positions) relative to a fixed service station, for example in a so-called carousel winder or similar type of machine.

The invention is not limited to such applications. It could be used, for example, to bring operating stations on a turntable of a machine tool into alignment with a stationary service position. Another possible use is in control of conveyor installation where a movable conveying means has a number of identifiable positions, any selected one of which may have to be aligned with a fixed station, for example a loading and/or unloading position.

In general, two parts to be located relative to each other are preferably relatively movable along a predetermined path. The speed of relative movement of the parts along the path during the locating operation must be adapted to the speed with which the locating apparatus can process information derived from the markers at the individual positions and the ability of the stopping means (mechanical brake, braking action of a motor or otherwise) to bring the parts to a relative halt.

The invention is especially useful where two parts are relatively movable along a predetermined path with a small spacing transverse to the path, and are required to be brought into a predetermined alignment or relative position with close tolerances in directions along the path but where their spacing in directions transverse to the path cannot be held within similarly close tolerances. In particular, the predetermined alignment or relative position may be any selected one of a plurality of such possible relative positions, those positions being spaced along the path by distances significantly greater than the required alignment tolerances at any individual position.

A marker representing a required relative position of the parts can be of the type generating a field having a field strength of which reduces in directions along the path away from the marker, i.e. a field effectively concentrated in the region of the marker. The field strength generated by the marker may also reduce in directions transverse to the path away from the marker.

A locating apparatus may be adapted to respond to the field to produce signals having levels dependent upon field strength. Means may be provided to compensate signal level variation caused by variable spacing of the marker and the locating apparatus in directions transverse to the path.

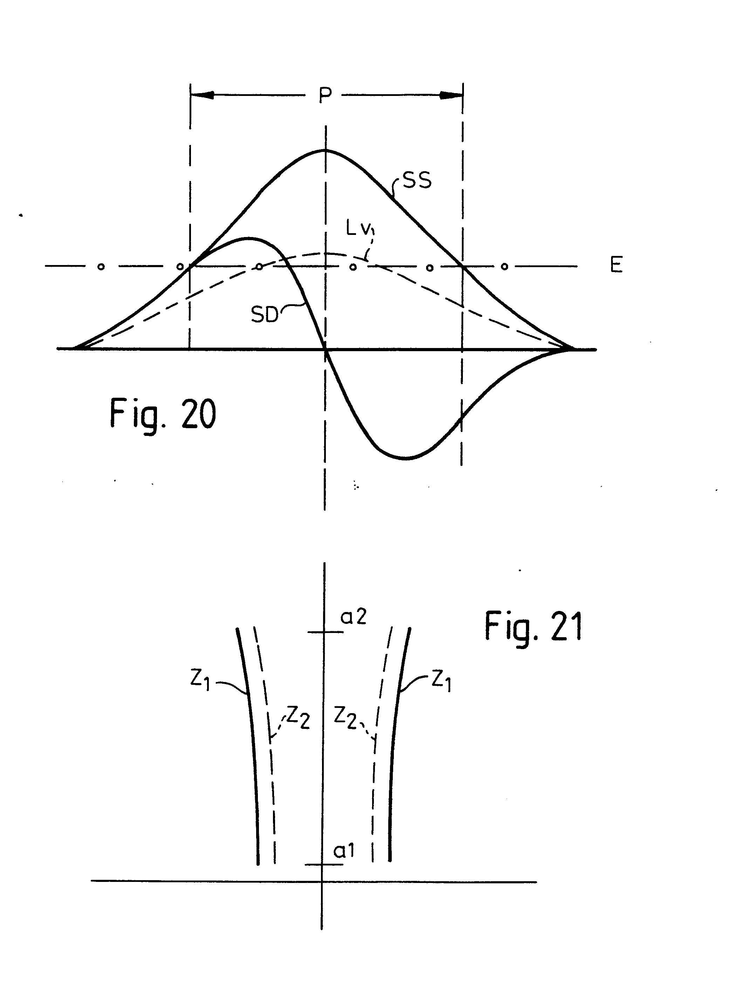

One example of such a compensating means, in the form already proposed in outline in the embodiment of Fig. 9, will now be explained in greater detail with reference to the diagrams in Figs. 20 and 21. Referring first to Fig. 20, this shows a signal pattern essentially the same as that described with reference to Fig. 5 in comprising a difference signal SD and a sum signal SS. Fig. 20 differs radically from Fig. 5, however, in relation to the definition of the threshold level shown in Fig. 5 by the simple horizontal L.

The threshold level Lv represented by the dotted curve in Fig. 20 is not a fixed value, but a variable which is a non-linear function of the sum signal SS. In the embodiment of Fig. 9, the non-linear function is generated by the unit 60. As mentioned in the description of Fig. 9, this function must be defined empirically since it is dependent upon the operating circumstances -it is not possible to formulate generally applicable rules.

Figure 20 shows only the positive-going threshold; a negative-going threshold can be generated by inverting the signal Lv. The tolerance band is defined between the intersection of positive threshold Lv with the positive half-wave of signal SD and the intersection of the inversion of signal Lv with the negative half-wave of signal SD.

It will be understood that the shape of signal Lv changes as the shape (peak height) of signal SS changes. The overall purpose of the variable threshold level Lv has already been explained with reference to Fig. 8A and B, namely the definition of a tolerance band of predetermined width (Z in Fig. 8) for the locating operation despite variation in effective field strength due to spacing tolerances in directions transverse to the path of movement. This effect is illustrated in a different manner in Fig. 21 which represents a coordinate system having its origin at the point where the axis A (Fig. 1) intersects the end face of magnet 10 adjacent the locating apparatus. Distance along the path of relative movement is represented on the horizontal axis and distance in the transverse direction on the vertical axis.

As before, axis A represents some "ideal" relative positioning of the parts and the aim is to define a band (tolerance band) to either side of the ideal such that relative positioning of the parts with the locating apparatus (or at least a field-sensitive portion thereof) within the band represents "acceptable" positioning. In fact, as explained with reference to Fig. 9, two such bands are desired, namely a coarse (or outer) tolerance band indicated in full lines Z1 in Fig. 21, and a fine (or inner) tolerance band indicated in dotted lines at Z2. Since these bands are defined in essentially the same way, the following discussion refers to one only (the outer band Z1) but the principles apply equally to the other band.

As shown in Fig. 21, some variation in the band width Z may be allowed in the transverse direction (along the vertical axis in the Figure). This implies that where the transverse spacing of the locating apparatus and marker can be kept low (a1 -vertical axis, Fig. 21) and accuracy of the locating operation will be greater than where the transverse spacing is relatively high (a2). The absolute accuracy requirements then define the maximum band width Z at the maximum anticipated transverse spacing a. The curvature of the band limits Z1 is determined by the function generator (60, Fig. 9) and must of course be adapted to the ability of the system to process the locating information and bring the parts to a relative halt. Reduction of this curvature can be achieved at the cost of improved mechanical accuracy (spacing a in the transverse direction) and/or additional electronic complexity (in the function generator 60).

By way of comparison with the variable threshold Lv, Fig. 20 also shows in dash-dotted line the fixed threshold E represented by the "enabling" unit 36 in Fig. 9 (also in Fig. 6). As already explained, the locating apparatus will not respond to any signals generated while the sum signal SS lies below the threshold E (i.e. outside the dotted vertical lines in Fig. 20). However, since threshold E is fixed, it does not define any particular band width P because the shape of curve SS can alter (as explained with reference to the similar diagram in Fig. 19A), giving a variable cut-off in relation to the fixed threshold. Correspondingly, the width P shown in Fig. 10 is actually variable and is effectively applied by circuitry following that shown in Fig. 9 to the signals L and R (Fig. 10) as well as the signals O shown in that Figure.

It will be appreciated that the particular compensating means described above is dependent upon the simultaneous generation of two signals dependent upon field strength, only one of which - (the difference signal SD) is used to determine actual location. Alternative compensating means employing serial generation of field-strength dependent signals have been described above. The previously described compensating means were based upon the use of signal level alone to determine position and involved a preliminary "interrogation" of the available field strength followed by a locating operation based upon the then known strength.

In a still further alternative, the compensating means may be based upon measurement of distance travelled, relying upon the symmetry of the field about some determinable axis ("ideal" location). In such a system, distance travelled after first detection of an "effective" field may be measured.

Two items of information are then required, namely (a) the point at which the effective field is lost (i.e. the field sensitive unit has passed completely through the effective field) and (b) the overrun beyond the effective field. Relative movement can then be reversed.

Reverse movement is not controlled according to signal level but according to distance travelled. The reverse movement must of course cancel the overrun. Furthermore, if the "band width" defined by the effective field is greater than a predetermined width, the reverse movement must be continued to bring the field sensitive unit within the narrower, predetermined band.

## IDENTIFICATION OF THE REQUIRED POSITION

In the Type II situation referred to above, means must be provided to identify the desired one of the possible relative positions. Arrangements for enabling this have already been described in the prior application and will not be discussed again in detail here. Those arrangements rely upon a "call signal" from an operating station at which a service tender is to be aligned. The control system for the tender then responds to the locating apparatus only after a call signal has been received.

The arrangement described in the prior application is not essential to the invention. Thus, if the "marker" is selectively energisable to generate the required field (e.g. an electromagnet), then the generation of the field itself can be used to identify a desired position. Alternatively, if information is separately available concerning the relative positioning of the parts, then a computer-controlled moving means can be adapted to bring the parts into a preliminary relation such that the "next" marker in the direction of movement represents the desired position at which the parts are to locate.

## MARKER FIELD PATTERNS

Assuming that the system is required to perform in the same way at each marker, the field patterns produced by a plurality of markers should be as near identical as reasonably possible. Where a large number of field generators are involved, each is preferably as simple as possible -each additional complicating factor increases the risk of inter-marker variability. The marker field is then preferably associated directly with the field generating element or elements, as in the case of a magnet. It is undesirable to interpose auxiliary elements, such as reflectors or focussing systems, between the field generator (energy source for the field) and the operating portion of the field, i.e. that portion actually intersected by the field sensitive element(s) of the locating apparatus.

Whichever type of field generator (magnetic, electrical, sonic, light) is used, the operating portion of the individual marker field should exhibit a known (identifiable) pattern in the directions of relative movement of the parts to be located -in the illustrated examples, the directions DL, DR on the path of movement of the locating apparatus. The "simplest" field pattern would involve an instantaneous change in field strength from zero to a predetermined level at some predetermined point along the path of relative movement, followed by an instantaneous return to zero field strength at some further predetermined point on the path. This could be created, for example, by a strongly focussed light beam (laser beam). However, the result will be an effective field (i.e. a field capable of inducing usable signals in a locating apparatus) extending in the transverse direction far beyond the path of the field sensitive element(s), and this is also undesirable in the great majority of cases. Limitation of the extent of the effective field in the transverse direction is therefore also desirable, so that the effective field does not extend very considerably beyond the operating portion thereof.

Accordingly, the preferred field pattern is one in which field strength is at a maximum at a predetermined position on the relative path of movement (the "principal axis A" in Fig. 1) and falls away to either side of this position along the path. The maximum field strength can be chosen such that the effective field does not extend in the transverse direction un duly beyond the operating portion thereof.

However, as described above, this field pattern can lead to difficulties where the "operating portion" cannot be closely defined because the path of relative movement cannot be closely defined. Then, field strength in the operating portion of the field may vary not only in the desired manner along the path of relative movement, but also in an undesired manner in the transverse direction. This in turn can make a compensating means essential.

Gate 70 referred to above in the description of Fig. 9 can be an AND-gate responding to an input from device 36 together with an input from either of amplifiers 52 and 58. Alternatively, gate 70 can be in the form of an OR-gate responsive to an input from either of amplifiers 52, 58 when suitably enabled by an input from device 36.

**Claims**

1. A textile machine comprising a plurality of operating stations, each having means adapted to generate an individual magnetic field, a service device and drive means for producing controlled relative movement between the operating stations and the service device, a locating apparatus being associated with the service device and being responsive to the magnetic fields to create output signals and a control means being provided to control said drive means to drive the service device and a selected operating station into alignment by reference to said output signals.

2. A machine as claimed in claim 1 wherein the operating stations are stationary and the service device is a travelling device, said means for producing relative movement comprising a drive motor to drive the service device past the stations.

3. A machine as claimed in claim 1 or claim 2 wherein each locating element is adapted to generate a field which is symmetrical about a predetermined axis in at least one plane containing the axis.

4. A machine as claimed in any preceding claim wherein the locating apparatus is adapted to respond to the individual magnetic fields individually.

5. A machine as claimed in claim 4 wherein said locating apparatus comprises a pair of magnetic field-sensitive elements, the instantaneous state of each element being dependent in use upon the field conditions to which it is subjected, the elements being spaced in the direction of relative movement such that they can respond as a pair to the field of one magnet.

6. A machine as claimed in claim 4 and 5 comprising comparing means adapted to generate a difference signal representing the instantaneous difference between signals from the field-sensitive elements.

7. A machine as claimed in any of claims 4 to 6 including means to generate a summation signal representing the instantaneous summation of signals from the field-sensitive elements.

8. A machine as claimed in any preceding claim comprising means to detect signal within a predetermined range of signal levels, said means being adjustable to vary the predetermined range in dependence upon a selected characteristic of the signal level generated by the locating apparatus in response to a particular field-generating means.

9. Equipment for use in locating relatively movable members comprising a field-generating means on one of said members, an apparatus on the other member responsive to said means to generate output signals, moving means for causing controlled relative movement of said members and control means responsive to said output signals and operative to control said moving means to bring the members into a position with said apparatus in a predetermined relationship to said field-generating means, as represented by a predetermined range of signal levels of said output signals, signal processing means being provided to process said output signals to operate said control means, said signal processing means being operable to adjust the predetermined range in dependence upon signal level from said apparatus.

10. A locating system comprising a field-generating member, a field-sensitive element the instantaneous state of which is dependent in use upon the field conditions to which it is subjected to affect output signals from the element, and means responsive to the state of the field sensitive element as represented by said output signals and adapted to select output signals lying within a predetermined range of signal levels and means for controllably adjusting said range in dependence upon the level of the output signals.

11. In combination, at least two movable members relatively movable along a predetermined path, one of said members having a plurality of field-generating devices, each adapted to generate an individual field, and the other member having a locating apparatus responsive to said fields individually to generate output signals in response thereto, moving means for causing relative movement of the members along said path and control means responsive to said output signals to control said moving means to locate the members with said locating apparatus in a predetermined relation to a selected one of said field generating devices.

12. The combination of claim 11 wherein each field-generating device is adapted to generate an individual magnetic field.

# Fig.1

# Fig. 2

# Fig. 4

Fig.5

# Fig. 6

Fig.3

Fig.7

Fig.8 A

SS

LP1

LN1

SD

Z

SS

LP 2

SD

LN2

Fig.8 B

Fig. 9

0 219 017

0 219 017

Fig. 10

## Fig. 11

## Fig. 12

## Fig. 13

## Fig 14

Fig.15

Fig.16

Fig.17

FIG.18

Fig. 19 A

Fig. 19 B

P

SS

Lv

SD

E

Fig. 20

a2

Fig. 21

Z₁

Z₁

Z₂

Z₂

a1

## DOCUMENTS CONSIDERED TO BE RELEVANT

| Category | Citation of document with indication, where appropriate, of relevant passages | Relevant to claim | CLASSIFICATION OF THE APPLICATION (Int. Cl.4) |
|---|---|---|---|
| X | CH-A- 448 833 (MASCHINENFABRIK SCHWEITER AG) * Column 3, lines 38-62; column 4, lines 41-55; column 5, lines 1-12 * | 1,2,4, 11,12 | D 01 H 15/00 H 03 K 17/95 |
| Y | | 3,5-8 | |
| Y | DE-A-2 515 582 (YAMATAKE-HONEYWELL) * Page 2, lines 16-20; claims * | 3,5-8 | |
| D,A | US-A-3 902 308 (BERNSTEIN et al.) * Figures 5a-c; column 7, lines 27-66; column 8, lines 59-67; column 9, lines 1-32 * | 1,3,6- 8 | |
| X | | 9,10 | TECHNICAL FIELDS SEARCHED (Int. Cl.4) D 01 H B 65 H H 03 K |
| A | FR-A-2 201 793 (FRANZ MORAT) * Page 2, lines 17-24; page 3, lines 31-39; pages 4,5; page 6, lines 1-23; page 10, lines 20-40; pages 11-13 * | 1-8,11 ,12 | G 05 B |
| X | | 9,10 | |

-/-

The present search report has been drawn up for all claims

| Place of search | Date of completion of the search | Examiner |
|---|---|---|
| THE HAGUE | 08-01-1987 | D HULSTER E.W.F. |

# EUROPEAN SEARCH REPORT

## DOCUMENTS CONSIDERED TO BE RELEVANT

Page 2

| Category | Citation of document with indication, where appropriate, of relevant passages | Relevant to claim | CLASSIFICATION OF THE APPLICATION (Int. Cl.4) |
|---|---|---|---|
| X | EP-A-0 028 079 (FUJITSU FANUC) * Page 5, lines 24-30; pages 6; page 7, lines 1-17 * | 9,10 | |
| | --- | | |
| X | EP-A-0 051 453 (FUJITSU FANUC) * Page 6; page 7, lines 1-16 * | 9,10 | |
| | --- | | |
| X | DE-A-2 027 892 (V.F.W.-FOKKER) * Whole document * | 9,10 | |
| | --- | | |
| A | US-A-3 636 543 (MAECKER°) * Column 2, lines 49-73; column 3, lines 68-75; claim 1 * | 9,10 | |
| | --- | | |
| A | FR-A-1 528 949 (NEYRPIC) | | |
| | --- | | **TECHNICAL FIELDS SEARCHED (Int. Cl.4)** |
| A | DE-B-1 270 111 (SIEMENS) | | |
| | --- | | |
| A | US-A-3 909 711 (BAUER et al.) | | |
| | ----- | | |

The present search report has been drawn up for all claims

| Place of search | Date of completion of the search | Examiner |
|---|---|---|
| THE HAGUE | 08-01-1987 | D HULSTER E.W.F. |

CATEGORY OF CITED DOCUMENTS

X : particularly relevant if taken alone
Y : particularly relevant if combined with another document of the same category
A : technological background
O : non-written disclosure
P : intermediate document

T : theory or principle underlying the invention
E : earlier patent document, but published on, or after the filing date
D : document cited in the application
L : document cited for other reasons

& : member of the same patent family, corresponding document

EPO Form 1503 03 82